# DEMANDE DE BREVET EUROPEEN

(11) **EP 1 840 973 A2**
(43) Date de publication de la demande: **03.10.2007**
(21) Numéro de dépôt: 07104784.9
(22) Date de dépôt: 23.03.2007
(51) Int. Cl.: H01L 31/0203, H01L 31/0232

(54) **Boîtier semi-conducteur à cage coulissante.**

(30) Priorité: 29.03.2006 FR 0602730
(71) Demandeur: STMICROELECTRONICS SA, 92120 Montrouge (FR)
(72) Inventeur: Brehignac, Rémi, 38000, GRENOBLE (FR); Diot, Jean-Luc, 38000, GRENOBLE (FR); Channon, Kevin, EDINBURGH, EH12 6AP (GB); Christison, Eric, EDINBURGH, EH3 9AT (GB)
(74) Mandataire: Zapalowicz, Francis

(57) **Abrégé**

Boîtier semi-conducteur destiné à être monté sur une plaque par l'intermédiaire de soudures, comprenant, disposés selon un axe, un composant semi-conducteur (2) présentant sur une face arrière des plots en saillie de connexion électrique (5) destinés à être soudés sur ladite plaque et une cage extérieure (16) entourant ledit composant et présentant un bord arrière destiné à être soudé sur ladite plaque et une partie avant traversée par une partie avant dudit composant ; ledit composant et ladite cage étant adaptés pour coulisser axialement l'un par rapport à l'autre de façon à être amenés dans leur position de soudage par rapport à ladite plaque et présentant des parties complémentaires de maintien (15, 19) venant en contact et destinées à les maintenir l'un par rapport à l'autre lorsqu'ils sont axialement éloignés de ladite position de soudage et à les libérer l'un par rapport à l'autre lorsqu'ils sont à ladite position de soudage.

## Description

La présente invention concerne le domaine des boîtiers semi-conducteurs destinés en particulier à être montés sur des plaques de circuits imprimés par l'intermédiaire de soudures, et plus particulièrement celui des boîtiers semi-conducteurs optiques ayant en particulier cette destination.

Dans le cas où de tels boîtiers semi-conducteurs optiques, constituant en particulier des caméras, sont montés sur des plaques ou cartes de circuits imprimés portant par ailleurs des composants rayonnants tels que des antennes, il peut se produire des perturbations des images, dues aux rayonnements électromagnétiques.

Par ailleurs, il peut être avantageux que de tels boîtiers semi-conducteurs optiques soient montés et soudés par une méthode dite de montage en surface dans laquelle les différents éléments sont posés sur les plaques ou cartes en des endroits déterminés munis de zones ou points de soudure. Ensuite, l'ensemble est passé dans un four pour provoquer leur soudage.

Le but de la présente invention est de proposer une solution répondant avantageusement aux deux problèmes ci-dessus.

Selon l'invention, le boîtier semi-conducteur destiné à être monté sur une plaque par l'intermédiaire de soudures, comprend, disposés selon un axe, un composant semi-conducteur présentant sur une face arrière des plots de connexion électrique destinés à être soudés sur ladite plaque, et une cage extérieure entourant ledit composant et présentant un bord arrière destiné à être soudé sur ladite plaque et une partie avant traversée par une partie avant dudit composant ; ledit composant et ladite cage étant adaptés pour coulisser axialement l'un par rapport à l'autre de façon à être amenés dans leur position de soudage par rapport à ladite plaque et présentant des parties complémentaires de maintien venant en contact et destinées à les maintenir l'un par rapport à l'autre lorsqu'ils sont axialement éloignés de ladite position de soudage et à les libérer l'un par rapport à l'autre lorsqu'ils sont à ladite position de soudage.

Selon l'invention, lesdites parties complémentaires de maintien sont de préférence disposées de façon à venir en contact lorsque ladite partie arrière dudit composant est rentrée dans ladite cage.

Selon l'invention, lesdites parties complémentaires de maintien sont de préférence réparties à la périphérie dudit composant.

Selon l'invention, lesdites parties complémentaires de maintien comprennent de préférence d'une part des rampes et d'autre part des pattes élastiques de maintien pouvant coulisser sur ces rampes.

Selon l'invention, lesdites rampes sont de préférence formées sur la périphérie de ladite partie avant dudit composant et lesdites pattes en saillie sont formées sur ladite partie avant de ladite cage.

Selon l'invention, lesdites rampes sont de préférence formées en saillie sur la périphérie de ladite partie avant dudit composant.

Selon l'invention, ledit bord arrière de ladite cage présente de préférence des crans.

Selon une variante préférée de l'invention, ledit composant semi-conducteur peut avantageusement comprendre une puce de circuits intégrés présentant sur sa face arrière lesdits plots de connexion électrique et sur sa face avant un capteur optique, une plaque transparente, un support tubulaire fixé sur la face avant de cette plaque transparente, à distance dudit capteur optique et une bague vissée dans ledit support tubulaire et portant une lentille placée en face dudit capteur, ledit support tubulaire traversant la partie avant de ladite cage et étant muni sur sa périphérie de l'un desdits moyens complémentaires de maintien.

Selon l'invention, la face arrière dudit support tubulaire présente de préférence des pieds dont les extrémités sont collées sur la face avant de ladite puce.

Selon une variante préférée de l'invention, ladite cage peut avantageusement comprendre une enveloppe tubulaire distante de la périphérie dudit composant et une paroi frontale présentant une ouverture traversée par la partie avant dudit composant et munie, dans cette ouverture, de l'un desdits moyens complémentaires de maintien.

Selon l'invention, ladite cage est métallique pour constituer une barrière électromagnétique.

La présente invention sera mieux comprise à l'étude d'un boîtier semi-conducteur optique, décrit à titre d'exemple non limitatif et illustré par le dessin sur lequel :
- La figure 1 représente une coupe axiale d'un boîtier semi-conducteur optique selon l'invention, en position de maintien ;
- La figure 2 représente une vue de côté du boîtier semi-conducteur optique de la figure 1 ;
- La figure 3 représente une vue arrière du boîtier semi-conducteur optique de la figure 1 ;
- La figure 4 représente une vue de dessus d'une plaque ou carte de circuits imprimés devant recevoir ledit boîtier semi-conducteur optique ;
- La figure 5 représente une coupe axiale dudit boîtier semi-conducteur optique, en position de soudage ;
- La figure 6 représente une vue de côté du boîtier semi-conducteur optique de la figure 5 ;
- Et la figure 7 représente, en coupe axiale, une variante d'exécution du boîtier semi-conducteur optique précité.

Le boîtier semi-conducteur 1 représenté sur les figures comprend un composant semi-conducteur 2 qui comprend un élément semi-conducteur 3 qui comprend une puce de circuits intégrés 3a, carrée, portée par une plaque de connexion électrique 4 munie, sur sa face arrière 4a, de plots en saillie de connexion électrique 5 constitués par des billes rapportées. La puce 3a présente sur sa face avant 6 un capteur optique central, ainsi que des plots de connexion électrique reliés aux plots 5 par des pistes contournant ses côtés.

L'élément semi-conducteur 3 comprend en outre une plaque transparente 7 de préférence en verre fixée par collage sur la face avant 6 de la puce 3a.

Le composant semi-conducteur 2 comprend, selon l'axe de la puce 3a, un support tubulaire 9, de préférence en une matière plastique non transparente, qui comprend une partie arrière 10, carrée, présentant deux pieds opposés 11 collés sur la face avant 8 de la plaque transparente 7 et une partie avant 12 approximativement cylindrique. La partie arrière 10 est légèrement plus grande que la puce 3a et le diamètre de la partie avant 12 est égal ou légèrement inférieur au côté de la partie arrière 10.

Le composant semi-conducteur 2 comprend en outre une bague 13, de préférence en une matière plastique non transparente, portant, dans son passage, une lentille optique 14 de focalisation vers le capteur optique de la puce 3a, cette bague 13 étant vissée dans le passage du support tubulaire 9 afin de pouvoir ajuster la distance entre cette lentille 14 et le capteur optique de la puce 3a.

Sur la périphérie de la partie avant 12 du support tubulaire 9 sont prévues, du côté de sa partie arrière 10, quatre nervures en saillie 15 constituant des rampes réparties à 90°.

Le boîtier semi-conducteur 1 représenté comprend en outre une cage métallique 16 qui comprend une enveloppe tubulaire carrée 17 qui entoure à distance la partie arrière 10 du support tubulaire 9 et une paroi avant 18 qui s'étend en avant de la partie arrière 10 du support tubulaire 9 et qui est traversée, avec un espacement ou jeu, par la partie avant 12 de ce support tubulaire 9.

Le bord intérieur de la cage 16 est muni de quatre pattes de maintien en saillie 19 qui s'étendent vers l'intérieur et qui sont recourbées vers l'avant et réparties à 90° en correspondance avec les nervures 15 de la partie avant 12 du support tubulaire 9.

Le bord arrière de l'enveloppe 17 de la cage 16 présente des crans espacés 20.

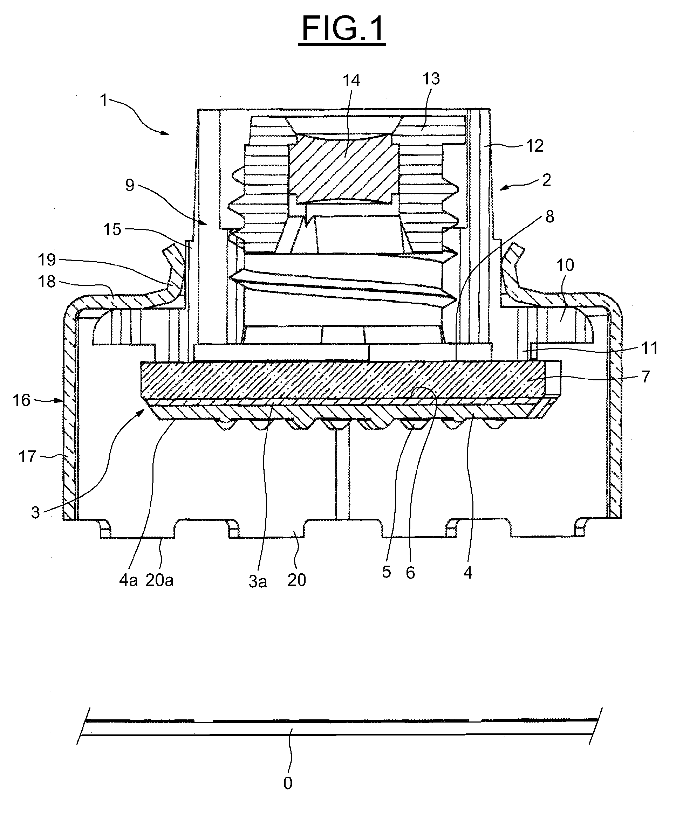

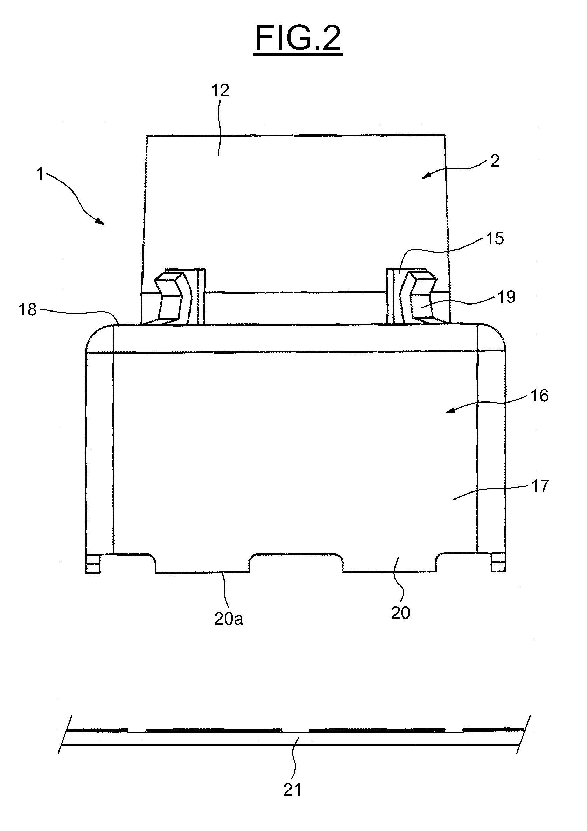

Comme le montrent les figures 1 et 2, lorsque la paroi avant 18 de la cage 16 est rapprochée de la partie arrière 10 du support tubulaire 9, les pattes de maintien 19 sont élastiquement en appui sur les nervures 15 de la partie avant 12 du support tubulaire 9, de telle sorte que les nervures 15 et les pattes de maintien 19 constituent des parties complémentaires de maintien du composant 2 par rapport à la cage 16. En outre, dans cette position de maintien, la partie arrière du composant 2 est rentrée dans l'enveloppe 17, de telle sorte que les plots de connexion électrique 5 sont en avant des bords d'extrémité 20a des crans 20 de l'enveloppe 17, et la partie avant 12 du support tubulaire 9 dépasse largement en avant de la paroi avant 18 de la cage 16.

Ayant fabriqué séparément le composant semi-conducteur 2 et la cage métallique 16, on engage de l'arrière vers l'avant le composant 2 au travers de la cage 17 et on enfile la partie avant 12 du support tubulaire 9 au travers de la paroi avant 18 de la cage 16, jusqu'à atteindre la position de maintien décrite ci-dessus. Cet ensemble est alors transportable sans être aisément séparable.

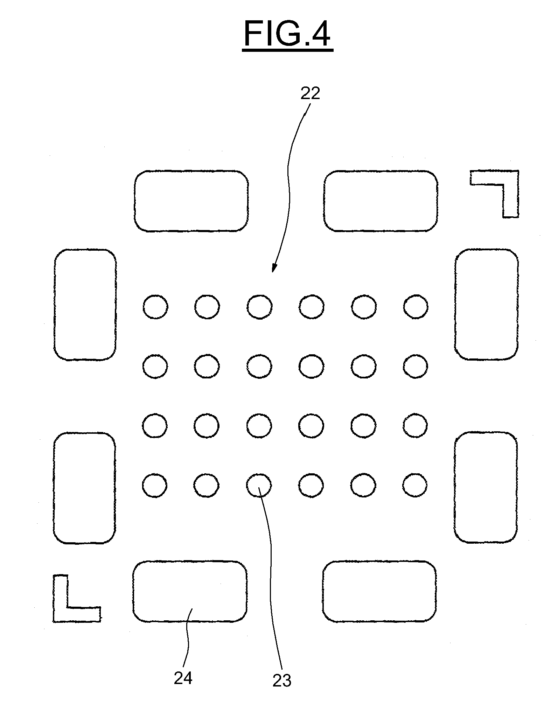

Comme le montre en particulier la figure 4, on peut disposer par ailleurs d'une plaque de réception ou carte de circuits imprimés 21 qui présente un emplacement 22 sur lequel sont prévus des points de soudure 23 répartis de façon à correspondre aux plots arrière de connexion électrique 5 du composant semi-conducteur 2 et des zones de soudure 24 réparties de façon à correspondre aux crans arrière 20 de la cage 16.

Pour monter le boîtier 1 sur la plaque 21 placée horizontalement, on peut procéder de la manière suivante.

Le boîtier 1 étant dans sa position de maintien décrite plus haut et représentée sur les figures 1 et 2, on saisit, par exemple à l'aide d'un bras manipulateur, la partie d'extrémité de la partie avant 12 du composant 2 et on amène le boîtier 1 au-dessus de l'emplacement 22 de la plaque de circuits imprimés 21.

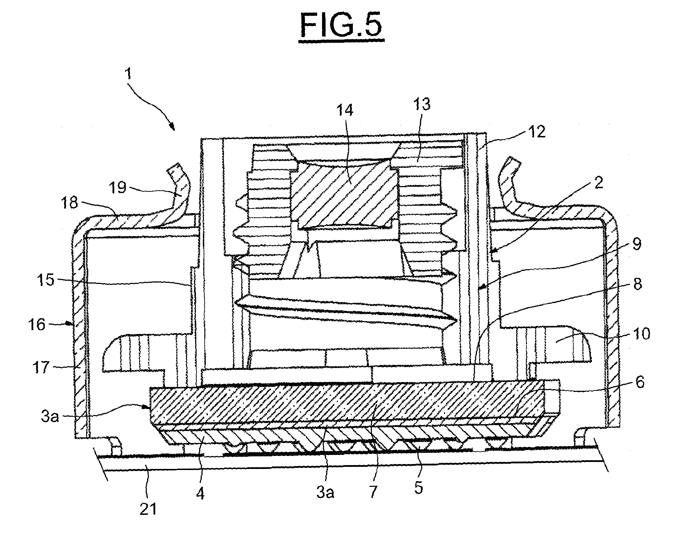

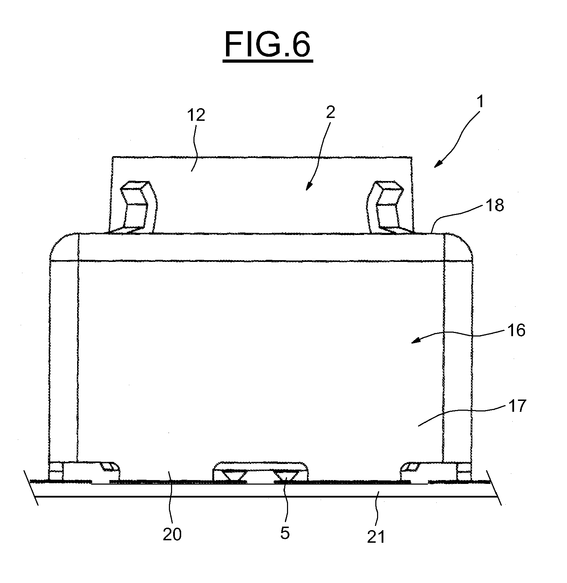

Ensuite, on descend le boîtier 1 vers l'emplacement de telle sorte que les bords arrière 20a des crans 20 de la cage 16 viennent en appui sur les zones de soudure 24. Poursuivant la descente du bras, la cage 16 reste immobilisée et le composant 2 poursuit sa descente en coulissant axialement par rapport à la cage, jusqu'à ce que les plots de connexion électrique 5 viennent en contact sur les points de soudure 23, comme le montrent les figures 5 et 6.

Avant que cette position de soudage ne soit atteinte, les pattes élastiques 19 de la cage 16 quittent les nervures en saillie 15 du composant 2, de telle sorte que lorsque cette position de soudage est atteinte, le composant 2 et la cage 16 sont libérés l'un par rapport à l'autre.

Le boîtier étant placé, on retire le bras manipulateur.

On peut alors passer la plaque de circuits imprimés 21 ainsi munie du boîtier 1 dans un four pour provoques la soudure des plots de connexion électrique 5 sur les points de soudure 23 et la soudure des crans 20 de la cage 16 sur les zones de soudure 24.

Il résulte de ce qui précède que, dans leur position de soudage, le composant 2 et la cage 16 sont distants l'un de l'autre et peuvent donc se déplacer l'un par rapport à l'autre afin de se placer correctement, par auto-centrage, lors de l'opération de soudage dans le four.

La cage étant métallique, elle constitue une barrière d'isolement électromagnétique de la puce 3a par rapport à l'environnement.

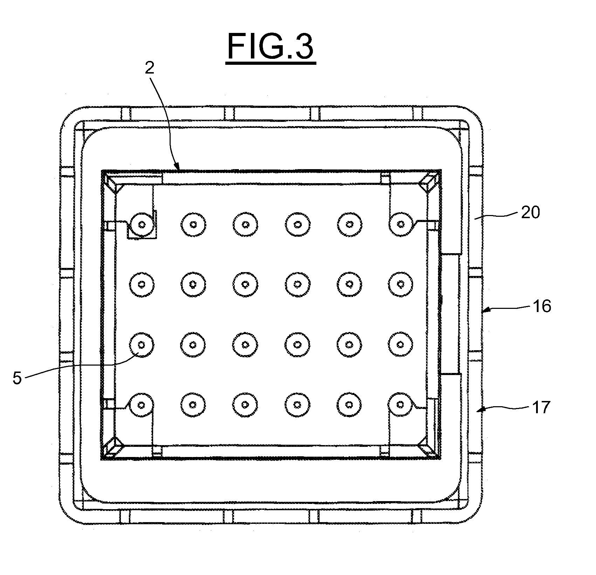

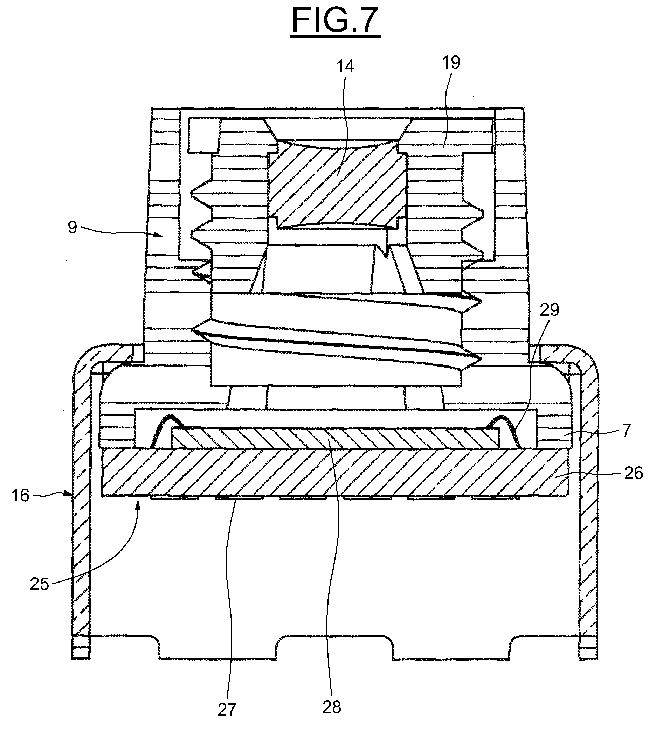

En se reportant à la figure 7, on peut voir qu'on a représenté une variante d'exécution de l'exemple décrit en référence aux figures 1 à 6.

Selon cette variante, l'élément semi-conducteur 3a est remplacé par un élément semi-conducteur 25 qui comprend une plaque support de connexion électrique 26 dont la face arrière présente des plots plats de connexion électrique 27 et une puce de circuits intégrés 28 fixée sur la face avant de la plaque support 26. Des plots avant de la puce 28 sont reliés à des plots avant de la plaque support 26 par des fils de connexion électrique 30, pour être reliés aux plots plats de connexion électrique 27.

Dans cet exemple, les pieds 11 du support tubulaire 9 sont fixés par collage sur la face avant de la plaque support 26, de part et d'autre et à distance de la puce 28 et des fils de connexion électrique 29.

Cette fois, ce sont les plots plats de connexion électrique 27 de l'élément semi-conducteur 25 qui sont destinés à être connectés aux plots 23 de la plaque de réception ou carte de circuits imprimés 21, comme on l'a décrit précédemment.

La présente invention ne se limite pas à l'exemple ci-dessus décrit. Des variantes sont possibles sans sortir du cadre défini par les revendications annexées.

## Revendications

1. Boîtier semi-conducteur destiné à être monté sur une plaque par l'intermédiaire de soudures, **caractérisé par le fait qu'**il comprend, disposés selon un axe,
un composant semi-conducteur (2) présentant sur une face arrière des plots de connexion électrique (5) destinés à être soudés sur ladite plaque
et une cage extérieure (16) entourant ledit composant et présentant un bord arrière destiné à être soudé sur ladite plaque et une partie avant traversée par une partie avant dudit composant ;
ledit composant et ladite cage étant adaptés pour coulisser axialement l'un par rapport à l'autre de façon à être amenés dans leur position de soudage par rapport à ladite plaque et présentant des parties complémentaires de maintien (15, 19) venant en contact et destinées à les maintenir l'un par rapport à l'autre lorsqu'ils sont axialement éloignés de ladite position de soudage et à les libérer l'un par rapport à l'autre lorsqu'ils sont à ladite position de soudage.

2. Boîtier selon la revendication 1, **caractérisé par le fait que** lesdites parties complémentaires de maintien (15, 19) sont disposées de façon à venir en contact lorsque ladite partie arrière dudit composant est rentrée dans ladite cage.

3. Boîtier selon l'une des revendications 1 et 2, **caractérisé par le fait que** lesdites parties complémentaires de maintien (15, 19) sont réparties à la périphérie dudit composant.

4. Boîtier selon l'une quelconque des revendications précédentes, **caractérisé par le fait que** lesdites parties complémentaires de maintien comprennent d'une part des rampes (15) et d'autre part des pattes élastiques de maintien (19) pouvant coulisser sur ces rampes.

5. Boîtier selon la revendication 4, **caractérisé par le fait que** lesdites rampes (15) sont formées sur la périphérie de ladite partie avant dudit composant et que lesdites pattes en saillie sont formées sur ladite partie avant de ladite cage.

6. Boîtier selon la revendication 5, **caractérisé par le fait que** lesdites rampes (15) sont formées en saillie sur la périphérie de ladite partie avant dudit composant.

7. Boîtier selon l'une quelconque des revendications précédentes, **caractérisé par le fait que** ledit bord arrière de ladite cage présente des crans (20).

8. Boîtier selon l'une quelconque des revendications précédentes, **caractérisé par le fait que** ledit composant comprend un élément muni desdits plots de connexion électrique (5) et comprenant une puce de circuits intégrés (3a) reliée à ces plots et présentant sur sa face avant un capteur optique, un support tubulaire (9) fixé sur ledit élément et présentant un passage en face dudit capteur optique et une bague (13) vissée dans ledit passage dudit support tubulaire et portant une lentille (14) placée en face dudit capteur, ledit support tubulaire traversant la partie avant de ladite cage et étant muni sur sa périphérie de l'un desdits moyens complémentaires de maintien (15).

9. Boîtier selon la revendication 8, **caractérisé par le fait que** ledit élément comprend une plaque transparente (7) placée en avant dudit capteur optique, ledit support tubulaire étant fixé sur cette plaque transparente.

10. Boîtier selon la revendication 8, **caractérisé par le fait que** ledit élément comprend une plaque support de connexion électrique dont la face arrière est munie desdits plots de connexion électrique et dont la face avant porte une puce de circuits intégrés (3a) reliée à ces plots, ledit support tubulaire étant fixé sur cette plaque support.

11. Boîtier selon l'une quelconque des revendication 8 à 10, **caractérisé par le fait que** la face arrière dudit support tubulaire présente des pieds (11) dont les extrémités sont collées sur ledit élément.

12. Boîtier selon l'une quelconque des revendications précédentes, **caractérisé par le fait que** ladite cage (16) comprend une enveloppe tubulaire (17) distante de la périphérie dudit composant et une paroi frontale (18) présentant une ouverture traversée par la partie avant dudit composant et munie, dans cette ouverture, de l'un desdits moyens complémentaires de maintien (19).

13. Boîtier selon l'une quelconque des revendications précédentes, **caractérisé par le fait que** ladite cage (16) est métallique pour constituer une barrière électromagnétique.
